(19) Europäisches Patentamt / European Patent Office / Office européen des brevets

(11) **EP 4 468 011 A1**

(12) **EUROPEAN PATENT APPLICATION**

(43) Date of publication:
**27.11.2024 Bulletin 2024/48**

(51) International Patent Classification (IPC):
*G01R 33/565* (2006.01)      *G06N 3/0464* (2023.01)
*G06N 3/084* (2023.01)      *G06N 3/02* (2006.01)

(21) Application number: **23175405.2**

(22) Date of filing: **25.05.2023**

(52) Cooperative Patent Classification (CPC):
**G01R 33/56509; G06N 3/0464;** G06N 3/048;
G06N 3/09

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Koninklijke Philips N.V.**
**5656 AG Eindhoven (NL)**

(72) Inventors:
• **LEE, Yoo Jin**
**Eindhoven (NL)**

• **NIELSEN, Tim**
**Eindhoven (NL)**
• **SOMMER, Karsten**
**5656AG Eindhoven (NL)**
• **MEINEKE, Jan Jakob**
**Eindhoven (NL)**
• **SCHUELKE, Christophe Michael Jean**
**Eindhoven (NL)**

(74) Representative: **Philips Intellectual Property & Standards**
**High Tech Campus 52**
**5656 AG Eindhoven (NL)**

(54) **MOTION CORRECTED MAGNETIC RESONANCE IMAGING**

(57)     Disclosed herein is a medical system (100, 300) comprising a memory (110) storing machine executable instructions (120) and a motion estimation neural network (122, 122', 122", 122‴), The motion estimation neural network is configured to output image transformation data (132, 132') in response to receiving a three-dimensional reference image (128, 128') and one or more three-dimensional test images (130, 130', 130"). The medical system further comprises a computational system (104), wherein execution of the machine executable instructions causes the computational system to: receive (200) k-space data descriptive of a three-dimensional field of view of a subject, wherein the k-space data is grouped into multiple bins (124); reconstruct (202) a motion corrected magnetic resonance image (134) from the k-space data using a model-based optimization; and provide (204) the motion corrected magnetic resonance image.

Fig. 4a

**Description**

FIELD OF THE INVENTION

The invention relates to magnetic resonance imaging, in particular to retrospective motion correction of a magnetic resonance image.

BACKGROUND OF THE INVENTION

A large static magnetic field is used by Magnetic Resonance Imaging (MRI) scanners to align the nuclear spins of atoms as part of the procedure for imaging the body of a patient. This large static magnetic field is referred to as the B0 field or the main magnetic field. Various quantities or properties of the subject can be measured spatially and imaged using MRI. A difficulty with performing magnetic resonance imaging is that it takes time to acquire the k-space data. This can leave a magnetic resonance image susceptible to various types of image artifacts such as blurring caused by subject motion during the acquisition of the k-space data.

The journal article Hossback et. al., "Deep learning-based motion quantification from k-space for fast model-based magnetic resonance imaging motion correction," Medical Physics, 2022 1-14, DOI: 10.1002/mp.16119 discloses a Motion Parameter Estimating Densenet (MoPED) that retrospectively estimates subject head motion during MRI acquisitions using a DL network with DenseBlocks and multitask learning. It quantifies the 2D rigid in-plane motion parameters slice-wise for each echo train (ET) of a Cartesian T2-weighted 2D Turbo-Spin-Echo sequence. The network receives a center patch of the motion corrupted k-space as well as an additional motion free low-resolution reference scan to provide the ground truth orientation.

SUMMARY OF THE INVENTION

The invention provides for a medical system, a method and a computer program in the independent claims. Embodiments are given in the dependent claims.

In one aspect the invention provides for a medical system that comprises a memory that stores machine-executable instructions and motion estimation neural network. The motion estimation neural network is configured to output image transformation data in response to receiving a three-dimensional reference image and one or more three-dimensional test images. The motion transformation is descriptive of an image transformation between the three-dimensional reference image and each of the one or more three-dimensional test images. The medical system further comprises a computational system. Execution of the machine-executable instructions causes the computational system to receive k-space data that is descriptive of a three-dimensional field of view of a subject. The k-space data is grouped into multiple bins. Execution of the machine-executable instructions further causes the computational system to reconstruct a motion-corrected magnetic resonance image from the k-space data using a model-based optimization. The computational system is configured to guide the model-based optimization using the image transformation data from the motion estimation neural network.

This embodiment may be beneficial because model-based optimizations, which may also be referred to as model-based reconstructions, take k-space data (the k-space data may be grouped into bins) and iteratively adjust the motion parameters or the image transformation data (for different bins of k-space data) using an optimization algorithm to correct for subject motion. It may be a non-convex optimization and may be extremely numerically intensive. Using a neural network to reduce the search space and/or to guide the optimization may result in a large reduction in the computational overhead and may in some cases enable a model-based optimization to succeed where it would not have been feasible before.

The motion estimation neural network is configured to receive one or more three-dimensional test images. If the motion estimation neural network receives multiple three dimensional-test images then it may have the advantage of being able to provide a series of image transformation data that are possibly more for more images more rapidly. If the motion estimation neural network is configured to receive only one three-dimensional test image, then multiple three-dimensional test images may be still be processed by using the motion estimation one time for each of the three-dimensional test images.

In another embodiment execution of the machine-executable instructions further causes the computational system to calculate a preliminary magnetic resonance image from the k-space data in each of the multiple bins. Execution of the machine-executable instructions further causes the computational system to receive a preliminary reference image comprising the three-dimensional field of view. Execution of the machine-executable instructions further causes the computational system to receive the image transformation data as an initial motion estimate in response to inputting the preliminary reference image as the three-dimensional reference image into the motion estimation neural network and the preliminary magnetic resonance image from the k-space data in the multiple bins as the one or more three-dimensional test images.

This embodiment may be beneficial because it essentially uses the motion estimation neural network to obtain a preliminary or initial value for the motion parameters or the image transformation data. This means that the model-based optimization can be started near the solution to the problem. This has several effects. In some cases, the model-based optimization may converge to the solution more rapidly because it started closer to the solution. Another potential benefit is that the model-based optimization may be located near the global minimum to start. This may for example eliminate the problem where the model-based optimization is stuck in a local minimum and prevents it from correctly converging to the global minimum.

In another embodiment guiding the model-based optimization using the motion estimation neural network comprises using the initial motion estimate to initialize the model-based optimization. As was mentioned above, this may be beneficial because it may provide for the initial starting point to be near the global minimum.

In another embodiment the model-based optimization is initialized by setting the initial motion parameters for individual bins of the multiple bins using the initial motion estimate. In this embodiment the individual motion parameters for the individual bins are set.

In another embodiment the guiding of the model-based optimization comprises using the initial motion estimate to identify bins of the multiple bins that have motion parameters within a predetermined range. The guiding of the model-based optimization further comprises combining bins within the predetermined range to reduce the number of multiple bins before beginning the model-based optimization. This embodiment may be beneficial because before the model-based optimization starts, bins which have motion parameters within the same predetermined range are combined together. This would have the effect of reducing the number of bins needed to be optimized in the model-based optimization. This may have the effect of greatly accelerating the model-based optimization as well as enabling some model-based optimizations to become feasible which were not before.

In another embodiment the preliminary reference image is a preliminary magnetic resonance image from the k-space data in each of the multiple bins chosen arbitrarily. That is to say, one of the preliminary magnetic resonance images is chosen. It may be beneficial to choose the preliminary magnetic resonance image from the first k-space bin because it is more likely to be aligned with a SENSE reference image, which may enable more robust or faster reconstruction.

In another embodiment the preliminary reference image is a temporary motion-corrected magnetic resonance image reconstructed from the k-space data taken from two or more of the multiple bins. For example, two of more of the multiple bins may have their k-space data combined and be used to reconstruct an image using temporary motion parameters. This may then be used as the preliminary reference image.

In another embodiment the preliminary reference image is a temporary motion-corrected magnetic resonance image reconstructed from the k-space data taken from all of the multiple bins.

In another embodiment the preliminary reference image is a non-motion-corrected magnetic resonance image reconstructed from the k-space data taken from two or more of the multiple bins. For example, two of more of the multiple bins may have their k-space data combined and be used to reconstruct an image that is not motion-corrected. This may then be used as the preliminary reference image.

In another embodiment the preliminary reference image is a non-motion-corrected magnetic resonance image reconstructed from the k-space data taken from all of the multiple bins.

In another embodiment the preliminary reference image is a reference image coming from a different scan or a pre-scan comprising the three-dimensional field of view. This reference image may for example be cropped or reduced in size so that it has the same field of view as the image is reconstructed from the bins of k-space data. In this embodiment images such as a SENSE reference or calibration image may also be used.

In another embodiment the model-based optimization is configured to iteratively reconstruct the motion-corrected magnetic resonance image. The iterative reconstruction comprises assigning a set of bin-specific temporary motion parameters to the multiple bins of k-space data. To begin a set of bin specific temporary motion parameters are initialized. Several options for this exist. In one example the bin specific temporary motion parameters may all be set to a predetermined value, for example, a null value for both translation and rotation in case of rigid-body motion. In other examples the initial motion estimate from the motion estimation neural network may be used for this initialization.

The iterative reconstruction further comprises reconstructing a temporary magnetic resonance image using the multiple bins of k-space data. These bins may for example be the original bins of k-space data that were received or the bins of k-space data after the rebinning process described above. The reconstruction of a temporary magnetic resonance image may be performed either only once using the initial bin specific motion parameters or in each iteration using the updated bin specific temporary motion parameters.

The iterative reconstruction further comprises calculating a preliminary magnetic resonance image from the k-space data in each of the multiple bins of k-space data and the set of bin specific motion parameters. The iterative reconstruction further comprises receiving the image transformation data as a temporary motion estimate in response to inputting the temporary magnetic resonance image as a three-dimensional reference image into the motion estimation neural network and the preliminary magnetic resonance image from the k-space data in the multiple bins as one of the one or more three-dimensional test images. The iterative reconstruction further comprises updating the bin-specific temporary motion parameters using the image transformation data for each of the multiple bins of k-space data.

This embodiment may be beneficial because it replaces a step-wise motion update with the motion estimation neural network. This for example may lead to a rapid convergence of the model-based optimization to a solution.

In another embodiment the model-based reconstruction is a joint optimization equation.

In another embodiment the image transformation data comprises a rigid body transformation between the three-dimensional reference image and each of the one or more three-dimensional test images. This may for example be useful in situations where the anatomy of the subject within the field of view has a more or less rigid structure, for example, if there is imaging of the head or brain of the subject.

In another embodiment the image transformation is a non-rigid transformation and the transformation data comprises a vector assigned to individual voxels of each of the one or more three-dimensional test images as a voxel-wise mapping between the three-dimensional reference image and each of the one or more three-dimensional test images. The computational system is configured to guide model-based optimization using the motion estimation neural network that outputs the vector assigned to the individual voxels of each of the one or more three-dimensional test images. Instead of being transformation data for the individual images as a rigid body transformation, the transformation data comprises vectors that map each voxel of the three-dimensional test image to the three-dimensional reference image or vice versa. This may be very useful in situations where the tissue is able to deform or move non-rigidly, for example, in an abdominal or chest region of a subject.

In another embodiment the medical system further comprises a magnetic resonance imaging system. The memory further stores pulse sequence commands configured for controlling the magnetic resonance imaging system to acquire the k-space data. The pulse sequence commands are configured to acquire the k-space data using multiple acquisition shots. Execution of the machine-executable instructions further causes the computational system to control the magnetic resonance imaging system with the pulse sequence commands to acquire the k-space data. Execution of the machine-executable instructions further causes the computational system to divide the k-space data into multiple bins such that the k-space data acquired during the same acquisition shot are in the same bin.

In another embodiment the pulse sequence commands are configured such that the k-space data sampling points in each acquisition shot are distributed evenly over a k-space sampling region. The k-space sampling region may for example be the region of k-space which is sampled for the particular field of view.

In another embodiment the k-space sampling points in each acquisition shot are distributed over the entire k-space sampling region using a DISORDER sampling strategy. A motion correction in a magnetic resonance image with DISORDER is a magnetic resonance imaging protocol called distributed incoherent sample orders for reconstructed deblurring using encoding redundancy. This may be advantageous because the sampling patterns for DISORDER may be particularly beneficial for retrospective motion estimation and reconstruction frameworks such as the model-based optimization used in examples here.

In another aspect the invention provides for a method of magnetic resonance imaging. The method comprises receiving k-space data that is descriptive of a three-dimensional field of view of a subject. The k-space data is grouped into multiple bins. Each of the multiple bins represents or contains k-space data that was acquired together during a single shot and has roughly the same motion position or parameters. The method further comprises reconstructing a motion-corrected magnetic resonance image from the k-space data using a model-based optimization. The computational system is configured to guide the model-based optimization using image transformation data from a motion estimation neural network.

The motion estimation neural network is configured to output image transformation in response to receiving a three-dimensional reference image and one or more three-dimensional test images. The motion transformation is descriptive of an image transformation between the three-dimensional reference image and each of the one or more three-dimensional test images. The method further comprises providing the motion-corrected magnetic resonance image.

In another aspect, the invention provides for a computer program product that comprises both a motion estimation neural network and machine-executable instructions. The machine-executable instructions may for example be contained on a non-transitory storage medium. The machine-executable instructions and/or the motion estimation neural network may be executable on a computational system. The motion estimation neural network is configured to output image transformation data in response to receiving a three-dimension reference image and one or more three-dimensional test images. The motion transformation is descriptive of an image transformation between the three-dimensional reference image and each of the one or more three-dimensional test images.

Execution of the machine-executable instructions causes a computational system to receive k-space data descriptive of a three-dimensional field of view of the subject and the k-space data is grouped into multiple bins. Execution of the machine-executable instructions further causes the computational system to reconstruct a motion-corrected magnetic resonance image from the k-space data using a model-based optimization. The computational system is configured to guide the model-based optimization using the image transformation data from the motion estimation neural network. Execution of the machine-executable instructions further causes the computational system to provide the motion-corrected magnetic resonance image.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

K-space data is defined herein as being the recorded measurements of radio frequency signals emitted by atomic spins using the antenna of a Magnetic resonance apparatus during a magnetic resonance imaging scan. Magnetic resonance data is an example of tomographic medical image data.

A Magnetic Resonance Imaging (MRI) image or MR image is defined herein as being the reconstructed two- or three-dimensional visualization of anatomic data contained within the magnetic resonance imaging data. This visualization can be performed using a computer.

BRIEF DESCRIPTION OF THE DRAWINGS

In the following preferred embodiments of the invention will be described, by way of example only, and with reference to the drawings in which:

Fig. 1 illustrates an example of a medical system;

Fig. 2 shows a flow chart which illustrates a method of using the medical system of Fig. 1;

Fig. 3 illustrates an example of a medical system;

Fig. 4 shows a flow chart which illustrates a method of using the medical system of Fig. 1;

Fig. 4a shows a flow chart which illustrates a further method of using the medical system of Fig. 1;

Fig. 5 illustrates the reconstruction of under-sampled images from k-space subsets;

Fig. 6 illustrates an example of a motion estimation neural network;

Fig. 7 illustrates a further example of a motion estimation neural network;

Fig. 8 illustrates a further example of a motion estimation neural network;

Fig. 9 illustrates a further example of a motion estimation neural network; and

Fig. 10 illustrates a method of generating training data for training the motion estimation neural network,

## DESCRIPTION OF EMBODIMENTS

Like numbered elements in these figures are either equivalent elements or perform the same function. Elements which have been discussed previously will not necessarily be discussed in later figures if the function is equivalent.

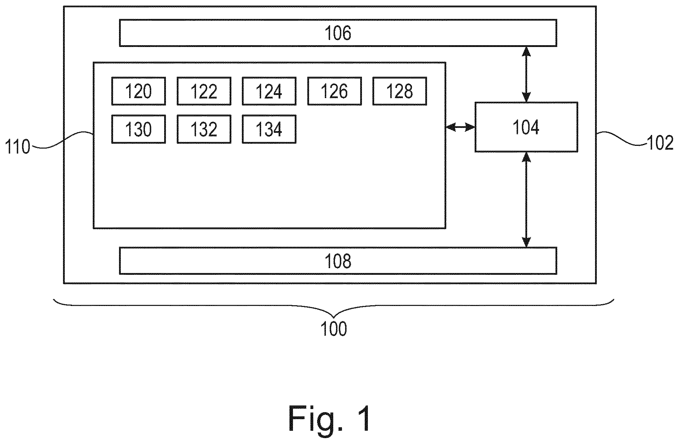

Fig. 1 illustrates an example of a medical system 100. The medical system 100 is shown as comprising a computer 102. The computer 102 may represent one or more computers or computing devices at one or more locations. The computer 102 could for example be incorporated into a magnetic resonance imaging system. The computer 102 could also, for example, be a server or workstation. In other examples, the computer 102 may be a virtual machine which provides computing systems across the internet or as a web-based service.

The computer 102 is shown as comprising a computational system 104. Likewise, the computational system 104 may represent one or more computing cores or computational systems. The computational system 104 is shown as being connected to an optional hardware interface 106. The hardware interface 106 may for example be a network connection and enabled it to communicate with other computers or computational systems. The hardware interface 106 may also be an interface which enables the computational system 104 to control other components or communicate with other components if the medical system 100 comprises these.

The computational system 104 is shown as being in further communication with an optional user interface 108, which may enable a user or operator of the medical system 100 to interact with and/or control the medical system. The computational system 104 is shown as being in further communication with a memory 110. The memory 110 is intended to represent various types of memory which the computational system 104 may be in communication with. In some examples, the memory 110 may be a non-transitory storage medium.

The memory 110 is shown as containing machine-executable instructions 120. The machine-executable instructions 120 may for example contain an operating system or other code which enables the computational system 104 to function. The machine-executable instructions 120 may also include software, which enables the computational system 104 to perform such things as numerical and image processing. For example, it may enable the reconstruction of magnetic resonance images as well as manipulating numerical data. The memory 110 is shown as further containing a motion estimation neural network 122. The motion estimation neural network is configured to output image transformation data in response to receiving a three-dimensional reference image and one or more three-dimensional test images. The motion transformation is descriptive an image transformation between the three-dimensional reference image and each of the one or more three-dimensional test images.

The memory 110 is further shown as containing multiple k-space bins 124. The multiple k-space bins 124 collectively hold the k-space data used for constructing a magnetic resonance image. The multiple k-space bins 124 represent groups of the k-space data that were, for example, acquired during a single shot or were acquired within a particular time period. The k-space data within a particular k-space bin is assumed to have an identical or nearly identical motion or coordinates.

The memory 110 is further shown as containing a model-based optimization algorithm 126. It may also be referred to as a model-based reconstruction algorithm. It receives the multiple k-space bins 124 and then outputs a motion-corrected magnetic resonance image 134. The model-based optimization algorithm 126 is guided by the motion estimation neural network 122 using several different techniques. The memory 110 is further shown as containing a three-dimensional reference image 128 and one or more three-dimensional test images 130 that were used as input to the motion estimation neural network 122 to obtain image transformation data 132, which is also shown as being stored in the memory 110. The image transformation data 132 is used to guide the model-based optimization algorithm 126 to perform motion correction. The memory 110 is further shown as containing the motion-corrected magnetic resonance image 134 which was output by the model-based optimization algorithm 126.

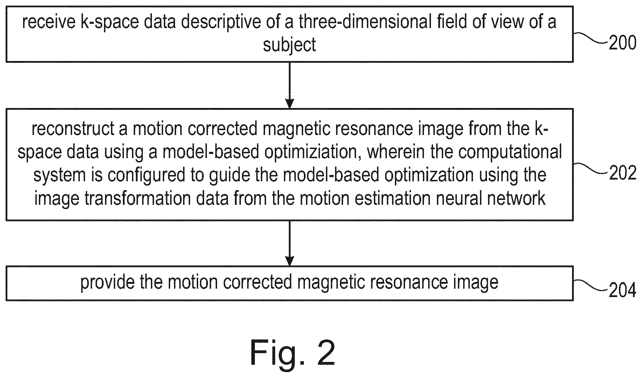

Fig. 2 shows a flowchart which illustrates a method of operating the medical system 100 of Fig. 1. In step 200 the k-space data is received, and it is descriptive of a three-dimensional field of view of a subject. The k-space data has been grouped into multiple k-space bins 124. The method further comprises reconstructing a motion-corrected magnetic resonance image 134 from the k-space data using a model-based optimization 126. The model-based optimization is guided using the image transformation data 132 from the motion estimation neural network 122. In step 204 the method comprises providing the motion-corrected magnetic resonance image 134. This may for example include storing it in a memory 110 or displaying it.

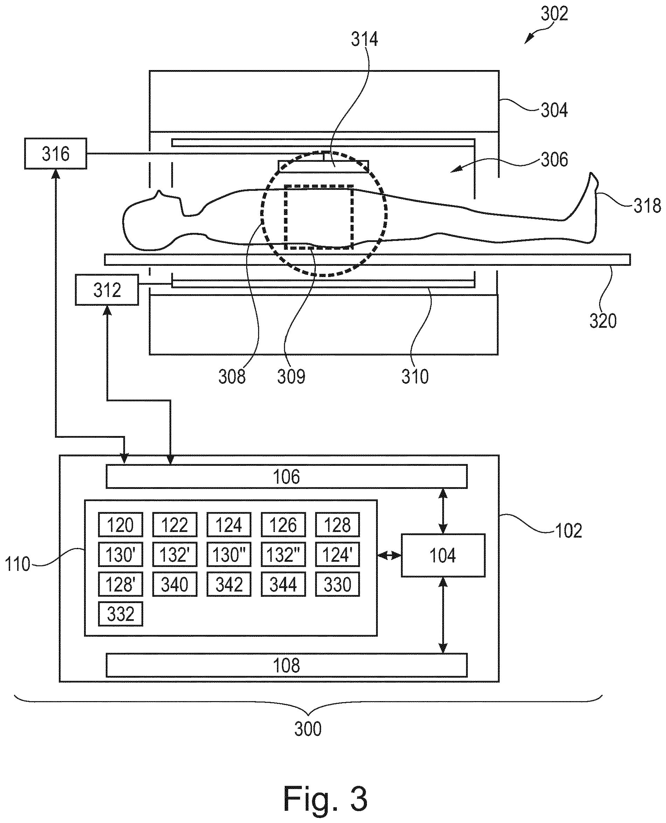

Fig. 3 illustrates a further example of a medical system 300. The medical system 300 is similar to the medical system 100 depicted in Fig. 1 except that it additionally comprises a magnetic resonance imaging system 302.

The magnetic resonance imaging system 302 comprises a magnet 304. The magnet 304 is a superconducting cylindrical type magnet with a bore 306 through it. It is also possible to use both a split cylindrical magnet and a so-called open magnet. A split cylindrical magnet is similar to a standard cylindrical magnet, except that the cryostat has been split into two sections to allow access to the isoplane of the magnet, such magnets may for instance be used in conjunction with charged particle beam therapy. An open magnet has two magnet sections, one above the other with a space in-between that is large enough to receive a subject. The arrangement of the two sections area is similar to that of a Helmholtz coil. Open magnets are popular because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A field of view 309 is shown within the imaging zone 308. The k-space data are acquired for the field of view 309. The region of interest could be identical with the field of view 309 or it could be a sub volume of the field of view 309. A subject 318 is shown as being supported by a subject support 320 such that at least a portion of the subject 318 is within the imaging zone 308 and the field of view 309.

Within the bore 306 of the magnet there is also a set of magnetic field gradient coils 310 which is used for the acquisition of measured k-space data to spatially encode magnetic spins within the imaging zone 308 of the magnet 304. The magnetic field gradient coils 310 are connected to a magnetic field gradient coil power supply 312. The magnetic field gradient coils 310 are intended to be representative. Typically, magnetic field gradient coils 310 contain three separate sets of coils for spatial encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 is a radio frequency coil 314 for manipulating the orientations of magnetic spins within the imaging zone 308 and for receiving radio transmissions from spins also within the imaging zone 308. The radio frequency antenna may contain multiple coil elements. The radio frequency antenna may also be referred to as a channel or antenna. The radio frequency coil 314 is connected to a radio frequency transceiver 316. The radio frequency coil 314 and radio frequency transceiver 316 may be replaced by separate transmit and receive coils and a separate transmitter and receiver. It is understood that the radio frequency coil 314 and the radio frequency transceiver 316 are representative. The radio frequency coil 314 is intended to also represent a dedicated transmit antenna and a dedicated receive antenna. Likewise, the transceiver 316 may also represent a separate transmitter and receiver. The radio frequency coil 314 may also have multiple receive/transmit elements and the radio frequency transceiver 316 may have multiple receive/transmit channels. The transceiver 316 and the gradient controller 312 are shown as being connected to the hardware interface 106 of the computer system 102.

The memory is further shows as containing pulse sequence commands 330 configured for acquiring k-space data 332. The k-space data 332 is then divided into the multiple bins 124 of k-space data.

The memory is further shown as comprising preliminary magnetic resonance images 130' constructed from each bin 124 of k-space data. The preliminary magnetic resonance images 130' function as the one or more three-dimensional test images to input into the motion estimation neural network 122. The memory 110 is further shown as containing a preliminary reference image 128 which functions as the three-dimensional reference image.

The memory 110 is further shown as containing the initial motion estimate 132' which is the image transformation data received in response to inputting the preliminary reference image 128' and the preliminary magnetic resonance images 130' into the motion estimation neural network 122. The initial motion estimate 132' may be used in several ways to help guide the model-based optimization 126. This may for example be used to rebin the multiple k-space bins 124 to combine these bins when they have motion states that are within the predetermined range. The memory 110 is further shown as containing rebinned multiple k-space bins 124' that has been constructed by using the initial motion estimate 132' to rebin the multiple k-space bins 124'.

The initial motion estimate 132' may also be used to provide initial motion coordinates for the multiple k-space bins 124 or the rebinned multiple k-space bins 124'. For example, in some cases the rebinning of the multiple k-space bins 124 may not be performed.

The memory 110 is further shown as containing bin-specific temporary motion parameters 340. These are motion parameters for a particular bin of the multiple k-space bins 124 or a particular bin of the rebinned multiple k-space bins 124'. Either the multiple k-space bins 124 are used to reconstruct an image or the rebinned multiple k-space bins 124' are used to reconstruct the image.

The memory 110 is further shown as containing a temporary magnetic resonance image 342. This is constructed from all of the bins 124 or 124' in the bin-specific temporary motion parameters 340. The memory 110 is further shown as containing a temporary motion estimate 344 that was received in response to inputting the temporary magnetic resonance image 342 and the preliminary magnetic resonance image for each of the bins 124' or 124 into the motion estimation neural network 122. The temporary motion estimate 344 may be used to update the bin-specific temporary motion parameters 340 on different iterations.

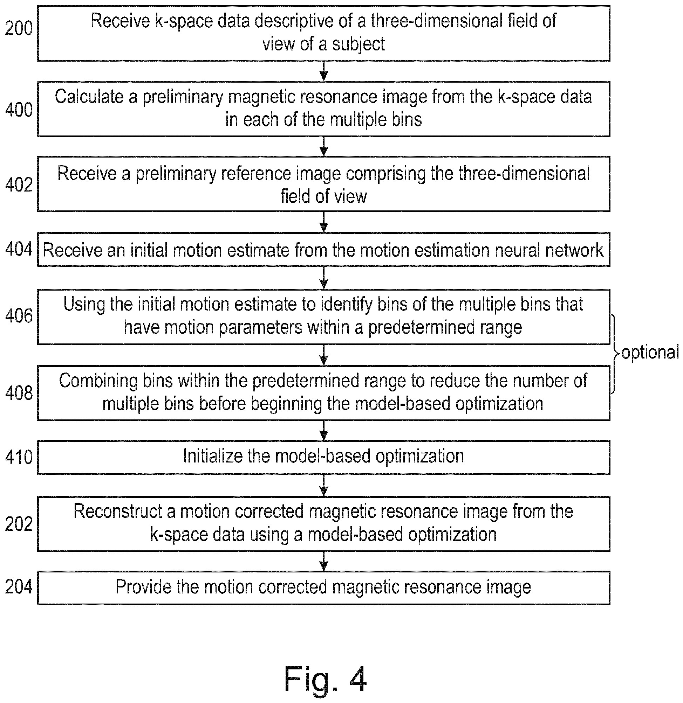

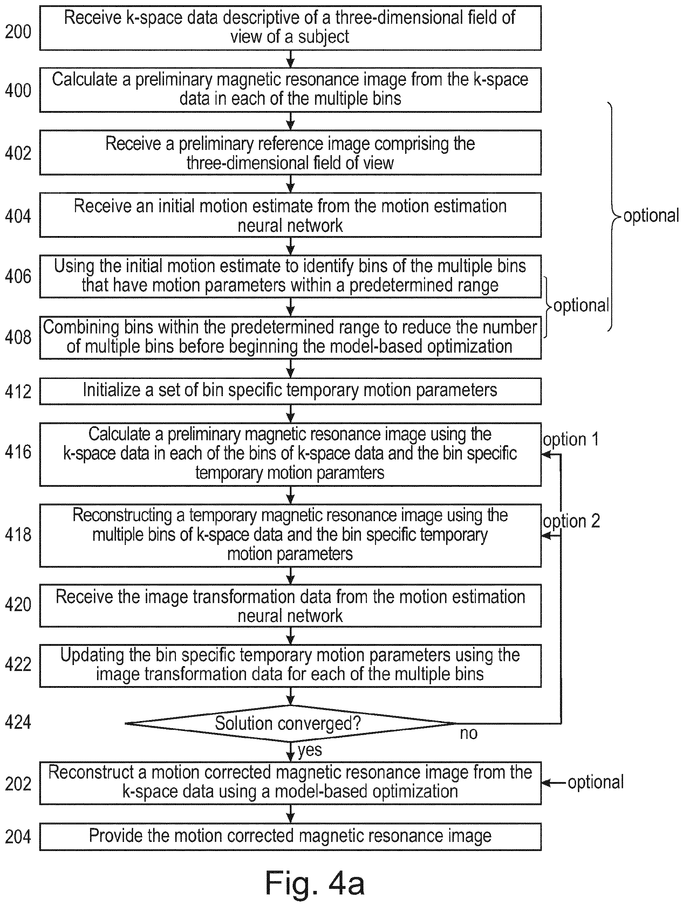

Fig. 4 shows a flowchart which illustrates a method of operating the medical system 300 of Fig. 3. The method may optionally begin with control the magnetic resonance imaging system 302 with the pulse sequence commands 330 to acquire the k-space data 332 and dividing the k-space data 332 into the multiple bins (124) such that k-space data acquired during the same acquisition shot are in the same bin.

In step 200 the k-space data, which has been divided into multiple k-space bins 124 is received. In step 400 a preliminary magnetic resonance image 130' is calculated from the k-space data in each of the multiple k-space bins 124. In step 402, a preliminary reference image 128' is received. In step 404, an initial motion estimate 132' is received as the image transformation data received from the motion estimation neural network 122 in response to inputting the preliminary reference image 128' and the preliminary magnetic resonance images 130' that were reconstructed from each bin of the multiple k-space bins 124. In step 406, initial motion estimate 132' is used to identify bins of the multiple k-space bins 124 that have motion parameters within a predetermined range. In step 408, the identified bins, which were determined to be within the predetermined range, are combined to reduce the number of multiple bins before beginning the model-based optimization. This results in the multiple k-space bins 124 being combined into the rebinned multiple k-space bins 124'. The steps 406 and 408 are optional.

In some examples, after performing steps 406 and 408 motion parameters can be estimated again using the neural network. For example, if one starts with 20 bins, in step 404, initial motion estimate is obtained using the neural network trained for 20 bins. If, for example, there was no motion during the second half of the scan, one can combine the last 10 bins into one bin. Then, one can estimate motion parameters for this combined bin using the neural network trained for 2 bins that possibly has higher accuracy than the neural network trained for 20 bins.

In step 410, the model-based optimization is guided by using the initial motion estimate 132' to set the initial motion parameters for individual bins of the multiple k-space bins 124 or the rebinned multiple k-space bins 124'. The multiple k-space bins 124 would be used if the rebinning process was not performed.

In step 202 the motion-corrected magnetic resonance image 134 is reconstructed from the k-space data using the model-based optimization. In step 204 the motion corrected magnetic resonance image is provided. This may for example include one or more of the following: storing the motion corrected magnetic resonance image in database, incorporating the image into a DICOM file, or rendering the image.

Fig. 4a shows a flow chart which illustrates a further method of operating the medical system of Fig. 3. Steps 200, 400, 402, 404, 406, and 408 are performed as was previously illustrated in Fig. 4. In some examples steps 406 and 408 are optional. In other examples, steps 400, 402, 404, 406, and 408 are optional.

In step 412, a set of bin-specific temporary motion parameters 340 is initialized. In the case that the calculation of the initial motion estimate 132' was performed, the initial motion estimate 132' could be used to initialize the bin-specific temporary motion parameters 340. Another option would be to simply set the bin-specific temporary motion parameters to a null value and begin the algorithm without setting specific temporary motion parameters. In step 416, a preliminary magnetic resonance image 130" is calculated from the k-space data in each of the multiple bins 124 or 124'. The reconstruction of a preliminary magnetic resonance image 130" may be performed either only once using the initial bin specific motion parameters from step 412 or in each iteration using the updated bin specific temporary motion parameters from step 422. In step 418, a temporary magnetic resonance image 342 is reconstructed using the multiple bins of k-space data and the bin specific temporary motion parameters.

In step 420, a temporary motion estimate 344 is received as the image transformation data from the motion estimation neural network 122 in response to inputting the preliminary magnetic resonance images 130" and the temporary magnetic resonance image 342. In step 422, the bin-specific temporary motion parameters 340 are updated using the temporary motion estimate 344 for each of the multiple bins. The method then proceeds to a decision block 424. The question is, has the solution converged. If the answer is "yes," the method proceeds to step 202 and a model-based optimization is performed to reconstruct a motion corrected magnetic resonance image 134 using the final bin specific motion parameters as initialization. This step is optional. If the answer is "no," the method proceeds back to step 416 or 418 again. In step 204, the final motion-corrected magnetic resonance image 134 is provided as was previously discussed above

Motion is one of the main sources of artifacts in MRI that degrade diagnostic utility, especially for long, high-resolution 3D scans. It often requires repeated scans, resulting in increased costs. There have been many approaches proposed to mitigate motion artifacts prospectively or retrospectively. Prospective motion correction methods measure the subject motion in real time and update the imaging coordinate system accordingly during the acquisition. For the measurement of real-time motion, these approaches require additional motion tracking devices or sequence modifications to acquire navigators, limiting the applications in clinical settings.

On the other hand, retrospective approaches have attempted to correct motion artifacts after data acquisition, mostly by incorporating the effect of motion into the encoding matrix and by jointly estimating a motion-free image and motion parameters. Although external motion tracking devices or navigators are advantageous also for retrospective approaches, it has been shown that motion artifacts could be corrected by solely relying on encoding redundancy in the measured data by modifying sample orders appropriately (DISORDER; Distributed and Incoherent Sample Orders for Reconstruction Deblurring using Encoding Redundancy).

This data-driven approach is attractive because it is readily applicable in clinical examinations without the need for extra hardware or sequence modifications.

In retrospective approaches, the joint estimation of motion-free image and motion parameters is a poorly conditioned non-convex optimization problem, which could possibly result in prohibitively long reconstruction times or finding a wrong local minimum. These problems can be tackled by introducing neural networks in various ways. One of them is to replace the entire motion correction algorithm with an image-to-image network that takes the corrupted image as an input and outputs the motion artifacts. While this method provides visually pleasing images with short processing times, it can have difficulties in dealing with unseen pathological data or can introduce synthetic structures. To avoid these problems, some suggested incorporating a neural network into the model-based reconstruction either by using the image-to-image network to remove motion artifacts during the motion update or by replacing the motion update with the neural network that estimates rigid-body motion parameters from corrupted k-space data. The latter requires navigator data as additional input to the network for the robust estimation of motion parameters.

As an example, a joint optimization for estimating the motion-free image (x) and rigid-body motion parameters (θ) can be formulated as follows:

$$\left(\hat{\mathbf{x}}, \widehat{\boldsymbol{\theta}}\right) = \underset{\mathbf{x}, \boldsymbol{\theta}}{\operatorname{argmin}} \|\mathbf{AFST}_{\boldsymbol{\theta}}\mathbf{x} - \boldsymbol{y}\|_2^2, \qquad \text{Eq. [1]}$$

where T is a set of rigid-body motion transformations, S are the coil sensitivities, F is the discrete Fourier transform, and A is a sampling mask. Here, a fixed number of motion states during the data acquisition (M) is assumed. Thus, the total number of motion parameters to estimate amounts to M x 6 for the 3D rigid-body motion (three translations and three rotations).

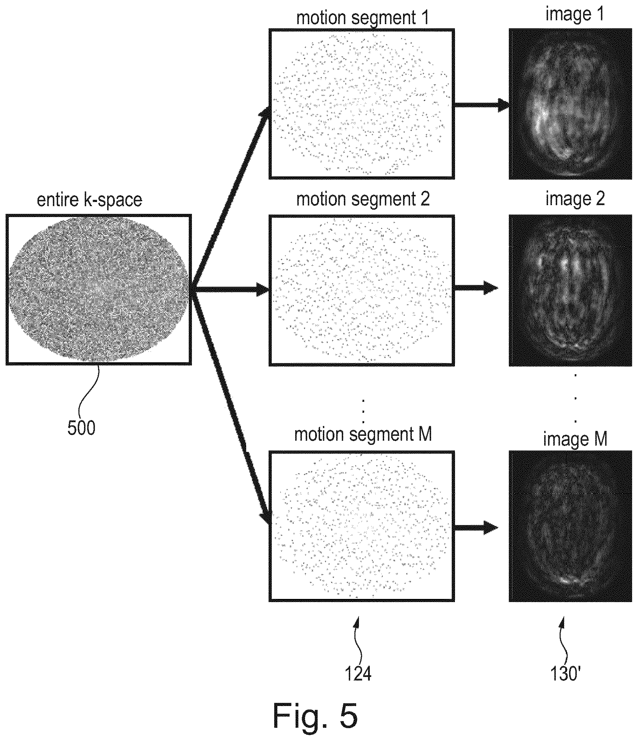

Fig. 5 illustrates the reconstruction of under-sampled images from k-space subsets. Item 500 represents the entire k-space for the region of interest 309. The k-space can be divided into different motion segments. These provide the multiple k-space bins 124. To the right of each bin, 124, is the preliminary magnetic resonance image 130' for each bin, 124. The preliminary magnetic resonance images 130' are of low resolution, are undersampled and do not have any clinical use. They can, however, be input into the motion estimation neural network 122.

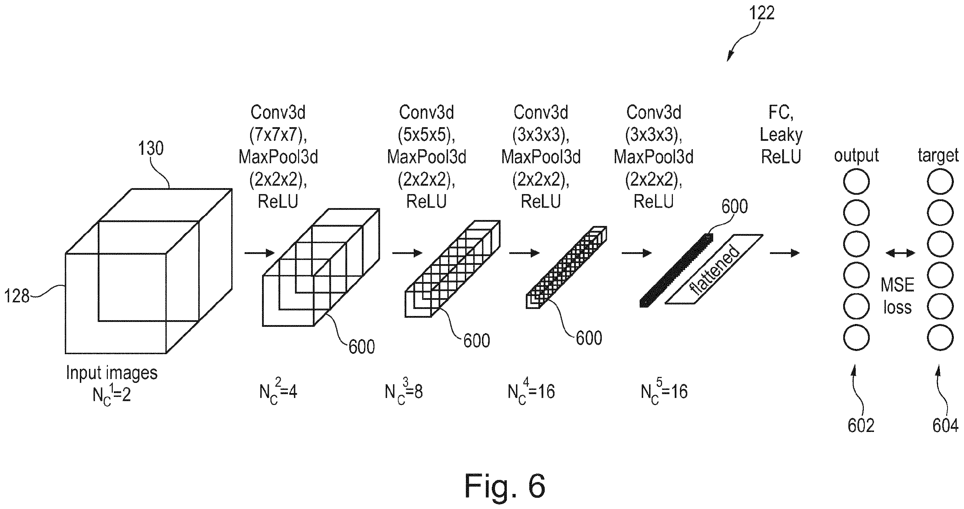

The proposed method reconstructs M under-sampled images from each of the M motion segments (cf. Fig. 5) and uses the neural network to estimate M x 6 rigid-body motion parameters from those under-sampled images. See Fig. 6 below for an exemplary neural network with two input images. Detailed description on the type and number of input images will follow.

The network output can improve the motion compensated reconstruction in different ways:
to initialize the motion parameters in the joint optimization. This would bring the starting point of the search closer to the global minimum, increasing the possibility of finding the global minimum and accelerating the optimization.

Additionally, the motion update step of each iteration can also be replaced by a neural network for potential further acceleration.

Moreover, if the network output indicates that there was no motion across multiple motion segments, these segments can be combined to reduce the number of motion segments, which would accelerate the iterative reconstruction.

Fig. 6 illustrates an exemplary neural network that receives two images as input. These may be the three-dimensional reference image 128 and a single three-dimensional test image 130. The architecture here can be scaled to receive more than one three-dimensional test image 130. There are four convolutional layers 600 and one fully-connected layer that are used to produce six rigid body motion parameters at the output 602. The output 602 is equivalent to the image transformation data 132. In the case of increasing the number of three-dimensional test images 130 the output 602 may be increased by six variables for each image that is added at the input. The column of dots labeled 604 represents a target used as a ground truth during training. This may be used for calculating a loss function.

The network architecture in Fig. 6 comprises two parts: The first part is composed of convolution and pooling operations. This part can be viewed as an encoder. The second part is composed of fully connected layers and can be viewed as a mapping from the encoded features to the motion model parameters. The flattened features of the last stage of the encoder part constitute the input to the mapping part. The output of the last stage of the mapping part are the estimated motion parameters.

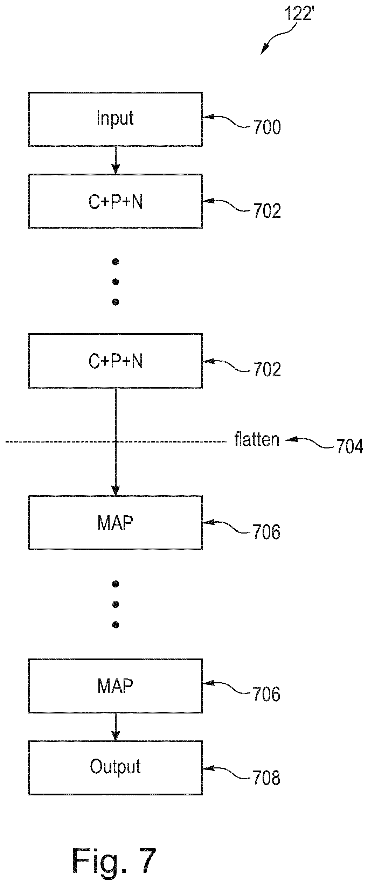

There are alternatives to the neural network architecture shown in Fig. 6. There are multiple ways to implement the encoder part: Fig. 7 shows one alternative implementation, where the encoder part is essentially the first half of a U-net [UNET]. It consists of a sequence of blocks which contain a convolution (C), pooling (P), and non-linear (N) operation.

Fig. 7 illustrates an alternative neural network architecture which uses a U-net style encoder with mapping for the motion estimation neural network 122'. There is an input 700 which receives the three-dimensional reference image 128 and the one or more three-dimensional test images 130. The first half of the neural network 122' comprises a number of combination, pooling, and non-linear operation blocks 702. This then goes to a flattening. After the flattening operation 704 there are a number of mapping blocks 706, which are then followed by an output block 708.

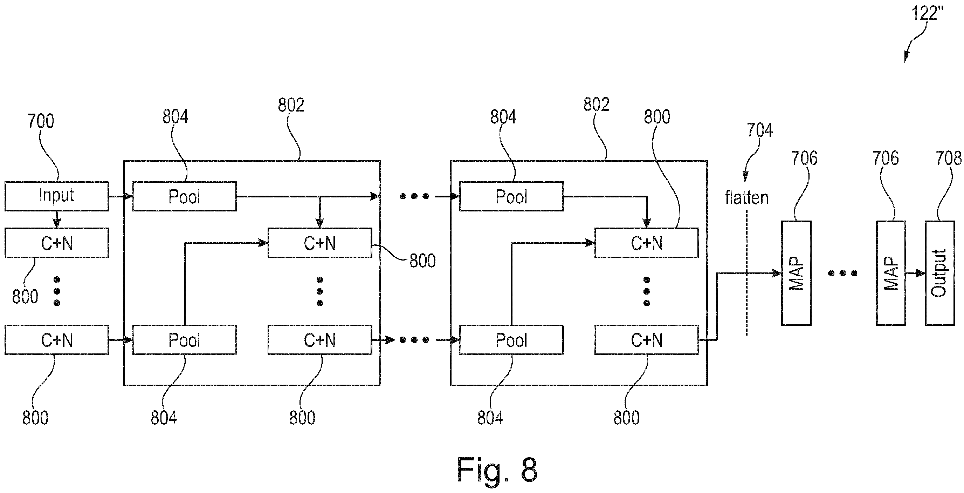

Figure 8 shows a different option to implement the encoder that is a Reversed multi-scale network with mapping. Here, multiple volumes at decreasing spatial resolution are created from the input volume. Each of these volumes is processed by a convolutional network. The output of the last convolutional stage of a higher spatial resolution is down-sampled and joined with the input of the following spatial scale. This architecture is similar to the multi-scale network used in [MS] except that the direction of joining the convolutional layers is reversed. In [MS], the final output has the same resolution as the input. Here, the final output has the same resolution as the lowest spatial scale.

In the alternative illustrated in Fig. 8, a further alternative of the motion estimation neural network 122" is shown. There is an input block 700, as was illustrated in Fig. 7, which is connected to a number of convolution and non-linear operation blocks 800. The input in the end of the chain of the convolution and non-linear operation blocks 800 is connected to a volume-reducing block 802. There are a sequence of these volume-reducing blocks that comprise a number of pooling layers 804 and additional convolution and non-linear operation blocks 800. The output of the final volume-reducing block 802 goes to the flattening operation 704, which is then fed into the mapping blocks 706, which then provides the output 708 as was illustrated in Fig. 7.

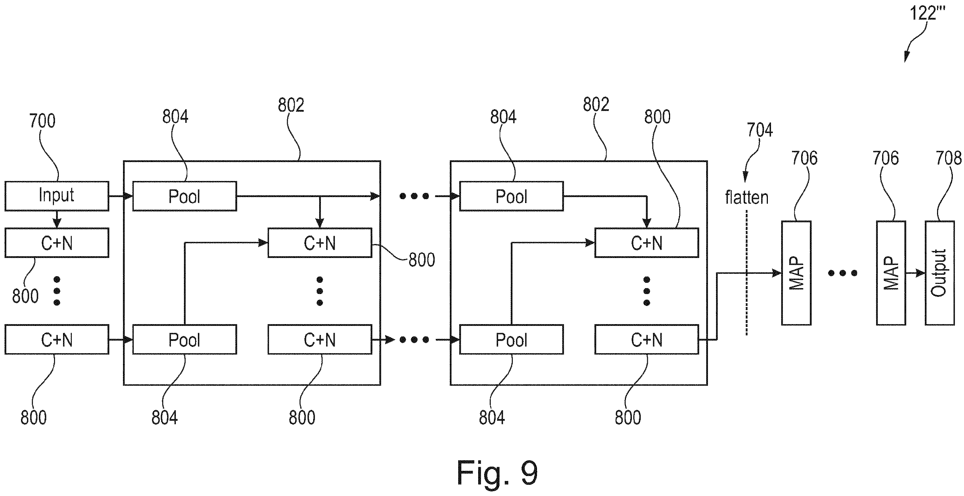

Fig. 9 shows a further alternative of the motion estimation neural network 122''' that has a Reversed F-net with mapping. The neural network in Fig. 9 is very similar to the neural network 122" in Fig. 8, except there are fewer connections within the volume-reducing block 802. Here, the joining of the features happens at the output of each convolutional net. This is similar to an F-net [FNET], except that - as before -- the direction of joining the features is reversed.

There a several variations of these general architectures. E.g., the convolutional blocks can include a batch normalization layer, or they can be operated in residual mode. I.e., there are skip connections around convolutional blocks. Another variation is the choice of the pooling operation (max, mean, ...) and the scale reduction factor. Here, a fixed factor (e.g. 2, 3, ...) or a fixed target resolution can be chosen. The second option is useful to make the number of output features independent from the number of voxels of the input volume. In this way, the same model can be applied to images with different numbers of voxels.

Also, for the non-linear operation several options exist such as ReLu and tanh functions. The mapping part is implemented as a sequence of blocks composed of a fully connected layer and nonlinearity. Again there are variations of this basic structure possible (batch normalization...).

The input for the motion estimation neural networks 122, 122', 122", 122" may take several different forms:

Option 1: Two under-sampled images can be provided as inputs to the network. In this case, the output of the network would be the relative motion between two images. To obtain the motion trajectory from all motion segments, all possible combinations of two under-sampled images out of M motion segments are put through the network, yielding one estimate of motion parameters pij for each pair of segment indices I, J. From this matrix of estimated motion between segments, the motion parameters pi for the segment i can be computed (up to one constant global transform) by minimizing the error between $\Sigma_{ij}\|T(p_{ij}) - T(p_j)T^{-1}(p_i)\|$, where $T(\cdot)$ is the motion transform and $T^{-1}(\cdot)$ the inverse.

Option 2: One of the two input images can be replaced by the image reconstructed from SENSE reference scan data. This SENSE image is then set as a reference motion state and put through the network together with each of the M under-sampled images, yielding the motion trajectory (total number of parameters = M x 6). As compared to Option 1 where the network would learn how to deal with different types of under-sampling artifacts, the network in Option 2 would additionally learn to extract motion information from different contrasts between SENSE and under-sampled images.

Option 3: The network takes two inputs; one of the under-sampled images and the image reconstructed from the entire k-space. The latter does not suffer from under-sampling artifacts but could be potentially corrupted by motion artifacts. This estimation could replace or be combined with the gradient-based motion parameter update to accelerate convergence.

Option 4: All M under-sampled images can be used simultaneously to estimate the motion trajectory. The total number of output parameters would be then M x 6 or (M-1) x 6 with or without providing the SENSE image as an additional input, respectively. Although more complex neural networks with more parameters as well as more training data would be needed, resulting in longer training time, the advantage of this approach is that a complete motion trajectory can be obtained from a single network, enabling possibilities to penalize extreme discontinuous motion between adjacent segments.

Typically, the different motion segments may contain different k-space points. But it could be advantageous to include repeated measurements of the same k-space point(s) in different segments (e.g., by oversampling the central k-space region). This would be in analogy to k-space navigator echoes. Using these navigator echoes in the proposed approach is straightforward, provided they are acquired at the correct echo time matching the rest of the imaging data.

The spatial resolution of the input images to the motion estimation network can be different from the resolution used in the motion compensated reconstruction. It could be beneficial to use a lower resolution to reduce under-sampling artifacts (for variable k-space sampling density where the center area is sampled more densely) and increase speed. However, if the resolution is too low the accuracy of the estimated parameters will be reduced.

Various methods of training the motion estimation neural network for the different options above is described below:

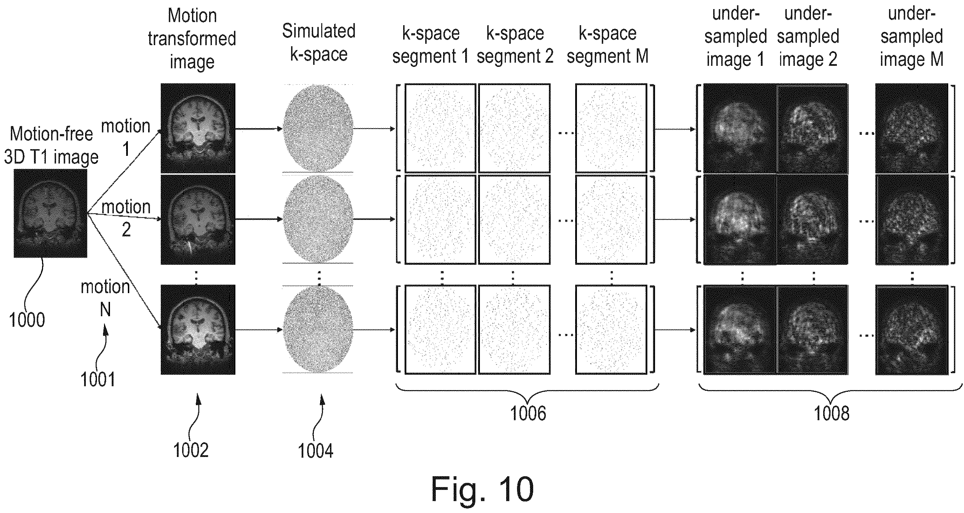

Option 1: Training data are generated by randomly selecting one set of rigid-body motion parameters, applying the forward model (Eq. [1]) to 3D images without motion artifacts, dividing k-space data into a fixed number of segments, and reconstructing images from these k-space subsets (cf. Fig. 10). By repeating this process N times with different motion parameters, N different sets of under-sampled images are generated, from which two under-sampled images are randomly selected with one condition that they come from different segments.

Fig. 10: Illustrates a procedure to generate training data for input option 1. Three different pairs of under-sampled images are shown as examples. Fig. 10 illustrates a method of generating training data for training the motion estimation neural network 122, 122', 122'', 122'''. To begin, there is a motion-free image 1000. Various motion transformations 1001 are used to provide a variety of transformed images 1002. The Fourier transform can be taken of these images to produce a simulated k-space 1004. The k-space data can then be divided into multiple bins 1006. Each of these bins results in an undersampled image 1008. Two undersampled images from 1008 are selected from two different bins; one for the three-dimensional reference image and the other for the three-dimensional test image. The neural network would then output motion parameters which can be compared against the motion parameters 1001. This process can be repeated many times and be used to generate accurate and effective training data.

Option 2: The same training data as in Option 1 are used except that only one of the under-sampled images is selected and paired with the SENSE image.

Option 3: The same procedure is taken as in Option 2, but the SENSE image is replaced by the image reconstructed using the entire k-space. Several versions of this fully-sampled image are generated including the image without motion and the images corrupted by motion. The motion-corrupted fully-sampled images are generated by randomly selecting motion trajectories, applying the forward model, and reconstructing images without motion correction.

Option 4: Training data are generated with the same procedure as in Option 1 except that M different sets of rigid-body motion parameters (one motion trajectory) are randomly selected instead of a single set of rigid-body motion parameters.

For options listed above, the neural network specific to the number of segments and k-space trajectory may be trained using the training data and the ground-truth motion parameters. Training several networks for different numbers of segments could be useful for the initialization of motion segments. Detailed explanations on how to use these networks will be provided in the next section.

The motion trajectory estimated from the neural network can be used to initialize motion parameters ($\theta$ in Eq. [1]) in the model-based reconstruction, making it more robust and faster. Furthermore, neural networks can help define motion segments by starting with a relatively high number of motion segments and combining consecutive segments that have the same motion states.

Because the network trained for the lower number of motion segments is expected to produce more accurate results, motion parameters can be estimated again after combining multiple segments using the neural network trained for the corresponding number of segments that is lower than the first estimation, which could increase the accuracy of motion estimation. This re-estimation of motion parameters would only work if Option 2 is used for input images. Reducing the number of motion segments in this way would drastically accelerate the reconstruction if the acquired data has only a few motion events.

For the potential further acceleration, neural networks can also be used to replace the motion update step in each iteration. In this case, the additional neural network is needed that takes the current estimate of a motion-free image ($x$ in Eq. [1]) and one of the under-sampled images as inputs (Option 3).

Although the description of this invention is focused on rigid-body motion, it is also possible to apply this method to non-rigid motion simply by defining T in Eq. [1] as a set of non-rigid motion transformations. The output of the network would then be the image filled with a vector in each voxel.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

REFERENCE SIGNS LIST

| | |
|---|---|
| 100 | medical system |
| 102 | computer |
| 104 | computational system |
| 106 | optional hardware interface |
| 108 | optional user interface |
| 110 | memory |
| 120 | machine executable instructions |
| 122 | motion estimation neural network |
| 122' | motion estimation neural network |
| 122" | motion estimation neural network |
| 122''' | motion estimation neural network |
| 124 | multiple k-space bins |
| 124' | rebinned multiple k-space bins |
| 126 | model-based optimization (reconstruction) algorithm |
| 128 | three-dimensional reference image |
| 128' | preliminary reference image |
| 130 | one or more three-dimensional test images |
| 130' | preliminary magnetic resonance images for each bin as the one or more three-dimensional test images |
| 130" | preliminary magnetic resonance image |
| 132 | image transformation data |
| 132' | initial motion estimate as the image transformation data |
| 134 | motion corrected magnetic resonance image |
| 200 | receive k-space data descriptive of a three-dimensional field of view of a subject, wherein the k-space data is grouped into multiple bins |
| 202 | reconstruct a motion corrected magnetic resonance image from the k-space data using a model-based optimization |
| 204 | provide the motion corrected magnetic resonance image |
| 300 | medical system |
| 302 | magnetic resonance imaging system |
| 304 | magnet |
| 306 | bore of magnet |
| 308 | imaging zone |
| 309 | field of view |
| 310 | magnetic field gradient coils |
| 312 | magnetic field gradient coil power supply |
| 314 | radio frequency coil |
| 316 | transceiver |
| 318 | subject |
| 320 | subject support |
| 330 | pulse sequence commands |
| 332 | k-space data |
| 340 | bin specific temporary motion parameters |
| 342 | temporary magnetic resonance image (from all bins using bin specific temp motion parameters) |
| 344 | temporary motion estimate as the tempoarary motion estimate |
| 346 | pulse sequence commands |
| 348 | k-space data |
| 400 | calculate a preliminary magnetic resonance image from the k-space data in each of the multiple bins |

402    receive a preliminary reference image comprising the three-dimensional field of view

404    receive the image transformation data as an initial motion estimate in response to inputting the preliminary reference image as the three-dimensional reference image into the motion estimation neural network and the preliminary magnetic resonance image from the k-space data in the multiple bins as the one or more three-dimensional test images

406    using the initial motion estimate to identify bins of the multiple bins that have motion parameters within a predetermined range

408    combining bins within the predetermined range to reduce the number of multiple bins before beginning the model-based optimization

410    initialize the model based-optimization

412    initialize a set of bin specific temporary motion parameters

416    calculate a preliminary magnetic resonance image using the k-space data in each of the bins of k-space data and the bin specific temporary motion parameters

418    reconstructing a temporary magnetic resonance image using the multiple bins of k-space data and the bin specific temporary motion parameters

420    receive the image transformation data as a temporary motion estimate in response to inputting the temporary magnetic resonance image as the three-dimensional reference image into the motion estimation neural network and the preliminary magnetic resonance image from the k-space data in the multiple bins of k-space data as the one or more three-dimensional test images

422    updating the bin specific temporary motion parameters using the image transformation data for each of the multiple bins

500    entire k-space

600    convolutional layer

602    output

604    target for training

700    input layer

702    combolution, pooling, and non-linear operation block

704    flatening block

706    Mapping block

800    convoluation and non-linear operation block

802    volume reducting block

804    polling layers

1000    motion free image

1001    motion transforms

1002    motion transformed image

1004    k-space data of motion transfomred image

1006    k-space data divided into bins

1008    undesrsampled image from k-space data of 1006

**Claims**

**1.**  A medical system (100, 300) comprising:

- a memory (110) storing machine executable instructions (120) and a motion estimation neural network (122, 122', 122", 122'''), wherein the motion estimation neural network is configured to output image transformation data (132, 132', 344) in response to receiving a three-dimensional reference image (128, 128', 342) and one or more three-dimensional test images (130, 130', 130"); wherein the motion transformation is descriptive of an image transformation between the three-dimensional reference image and each of the one or more three-dimensional test images;

- a computational system (104), wherein execution of the machine executable instructions causes the computational system to:

- receive (200) k-space data descriptive of a three-dimensional field of view of a subject, wherein the k-space data is grouped into multiple bins (124);
- reconstruct (202) a motion corrected magnetic resonance image (134) from the k-space data using a model-based optimization, wherein the computational system is configured to guide the model-based optimization using the image transformation data from the motion estimation neural network; and
- provide (204) the motion corrected magnetic resonance image.

2. The medical system of claim 1, wherein execution of the machine executable instructions further causes the computational system to:

   - calculate (400) a preliminary magnetic resonance image (130') from the k-space data in each of the multiple bins;
   - receive (402) a preliminary reference image (128') comprising the three-dimensional field of view; and
   - receive (404) the image transformation data as an initial motion estimate (132') in response to inputting the preliminary reference image as the three-dimensional reference image into the motion estimation neural network and the preliminary magnetic resonance image from the k-space data in the multiple bins as the one or more three-dimensional test images.

3. The medical system of claim 2, wherein guiding the model-based optimization using the motion estimation neural network comprises using the initial motion estimate to initialize (410) the model based-optimization.

4. The medical system of claim 3, wherein the model-based optimization is initialized by setting initial motion parameters for individual bins of the multiple bins using the initial motion estimate.

5. The medical system of claim 2, 3, or 4, wherein guiding the model-based optimization comprises:

   - using (406) the initial motion estimate to identify bins of the multiple bins that have motion parameters within a predetermined range; and
   - combining (408) bins (124') within the predetermined range to reduce the number of multiple bins before beginning the model-based optimization.

6. The medical system of any one of claims 2 through 5 wherein the preliminary reference image is any one of the following: a preliminary magnetic resonance image from the k-space data in each of the multiple bins chosen arbitrarily, a non-motion corrected magnetic resonance image reconstructed from k-space data taken from two or more of the multiple bins, a non-motion corrected magnetic resonance image reconstructed from k-space data taken from all of the multiple bins, a temporary motion corrected magnetic resonance image reconstructed from k-space data taken from two or more of the multiple bins, a temporary motion corrected magnetic resonance image reconstructed from k-space data taken from all of the multiple bins, and a reference image coming from a different scan or prescan comprising the three-dimensional field of view.

7. The medical system of any one of the preceding claims, wherein the model-based optimization is configured to initialize (412) a set of bin specific temporary motion parameters (340), wherein the set of bin specific temporary motion parameters is assigned to the multiple bins of k-space data, wherein the model-based optimization is configured to iteratively reconstruct the motion corrected magnetic resonance image comprising:

   - calculating (416) a preliminary magnetic resonance image (402) from the k-space data in each of the bins of k-space data and the set of bin specific motion parameters;
   - reconstructing (418) a temporary magnetic resonance image (342) using the multiple bins of k-space data;
   - receiving (420) the image transformation data as a temporary motion estimate (344) in response to inputting the temporary magnetic resonance image as the three-dimensional reference image into the motion estimation neural network and the preliminary magnetic resonance image from the k-space data in the multiple bins of k-space data as the one or more three-dimensional test images; and
   - updating (422) the bin specific temporary motion parameters using the image transformation data for each of the multiple bins.

8. The medical system of any one of the preceding claims, wherein the model-based reconstruction is a joint optimization equation.

9. The system of any one of the preceding claims, wherein the image transformation data comprises a rigid body transformation between the three-dimensional reference image and each of the one or more three-dimensional test images.

10. The system of any one of claims 1 through 8, wherein the image transformation is a non-rigid transformation and the image transformation data comprises a vector assigned to individual voxels of each of the one or more three-dimensional test images as a voxel wise mapping between the three-dimensional reference image and each of the one or more three-dimensional test images, and wherein the computational system is configured to guide the model-based optimization using the motion estimation neural network that outputs the vector assigned to the individual voxels of each of the one or more three-dimensional test images.

11. The system of any one of the preceding claims, wherein the medical system further comprises a magnetic resonance imaging system (302), wherein the memory further stores pulse sequence commands (330) configured for controlling the magnetic resonance imaging system to acquire k-space data (332), wherein the pulse sequence commands are configured to acquire the k-space data using multiple acquisition shots, wherein execution of the machine executable instructions further causes the computational system to:

- control the magnetic resonance imaging system with the pulse sequence commands to acquire the k-space data; and
- divide the k-space data into the multiple bins such that k-space data acquired during the same acquisition shot are in the same bin.

12. The system of claim 11, wherein the pulse sequence commands are configured such that k-space sampling points in each acquisition shot are distributed evenly over a k-space sampling region.

13. The system of claim 12, wherein the k-space sampling points in each acquisition shot are distributed over the entire k-space sampling region using a DISORDER sampling strategy.

14. A method of magnetic resonance imaging, wherein the method comprises:

- receiving (200) k-space data descriptive of a three-dimensional field of view of a subject, wherein the k-space data is grouped into multiple bins (124);
- reconstructing (202) a motion corrected magnetic resonance image from the k-space data using a model-based optimization, wherein the computational system is configured to guide the model-based optimization using image transformation data from a motion estimation neural network (122, 122', 122", 122'''), wherein the motion estimation neural network is configured to output image transformation data (132, 132', 344) in response to receiving a three-dimensional reference image (128, 128', 342) and one or more three-dimensional test images (130, 130', 130"), wherein the motion transformation is descriptive of an image transformation between the three-dimensional reference image and each of the one or more three-dimensional test images; and
- providing (204) the motion corrected magnetic resonance image.

15. A computer program product comprising machine executable instructions (120) and a motion estimation neural network (122, 122', 122", 122'''), wherein the motion estimation neural network is configured to output image transformation data (132, 132', 344) in response to receiving a three-dimensional reference image (128, 128', 342) and one or more three-dimensional test images (130, 130', 130"); wherein the motion transformation is descriptive of an image transformation between the three-dimensional reference image and each of the one or more three-dimensional test images; wherein execution of the machine executable instructions causes a computational system to:

- receive (200) k-space data descriptive of a three-dimensional field of view of a subject, wherein the k-space data is grouped into multiple bins (124);
- reconstruct (202) a motion corrected magnetic resonance image from the k-space data using a model-based optimization, wherein the computational system is configured to guide the model-based optimization using the image transformation data from the motion estimation neural network; and
- provide (204) the motion corrected magnetic resonance image.

Fig. 1

| receive k-space data descriptive of a three-dimensional field of view of a subject | 200 |

| reconstruct a motion corrected magnetic resonance image from the k-space data using a model-based optimiziation, wherein the computational system is configured to guide the model-based optimization using the image transformation data from the motion estimation neural network | 202 |

| provide the motion corrected magnetic resonance image | 204 |

# Fig. 2

Fig. 3

200 | Receive k-space data descriptive of a three-dimensional field of view of a subject

400 | Calculate a preliminary magnetic resonance image from the k-space data in each of the multiple bins

402 | Receive a preliminary reference image comprising the three-dimensional field of view

404 | Receive an initial motion estimate from the motion estimation neural network

406 | Using the initial motion estimate to identify bins of the multiple bins that have motion parameters within a predetermined range

408 | Combining bins within the predetermined range to reduce the number of multiple bins before beginning the model-based optimization

} optional

410 | Initialize the model-based optimization

202 | Reconstruct a motion corrected magnetic resonance image from the k-space data using a model-based optimization

204 | Provide the motion corrected magnetic resonance image

# Fig. 4

| 200 | Receive k-space data descriptive of a three-dimensional field of view of a subject |
|---|---|

| 400 | Calculate a preliminary magnetic resonance image from the k-space data in each of the multiple bins |
|---|---|

| 402 | Receive a preliminary reference image comprising the three-dimensional field of view |
|---|---|

optional

| 404 | Receive an initial motion estimate from the motion estimation neural network |
|---|---|

| 406 | Using the initial motion estimate to identify bins of the multiple bins that have motion parameters within a predetermined range |
|---|---|

optional

| 408 | Combining bins within the predetermined range to reduce the number of multiple bins before beginning the model-based optimization |
|---|---|

| 412 | Initialize a set of bin specific temporary motion parameters |
|---|---|

| 416 | Calculate a preliminary magnetic resonance image using the k-space data in each of the bins of k-space data and the bin specific temporary motion paramters |
|---|---|

option 1

| 418 | Reconstructing a temporary magnetic resonance image using the multiple bins of k-space data and the bin specific temporary motion parameters |
|---|---|

option 2

| 420 | Receive the image transformation data from the motion estimation neural network |
|---|---|

| 422 | Updating the bin specific temporary motion parameters using the image transformation data for each of the multiple bins |
|---|---|

424 — Solution converged? — no

↓ yes

| 202 | Reconstruct a motion corrected magnetic resonance image from the k-space data using a model-based optimization |
|---|---|

optional

| 204 | Provide the motion corrected magnetic resonance image |
|---|---|

Fig. 4a

Fig. 5

Fig. 6

122'

Input — 700

C+P+N — 702

⋮

C+P+N — 702

- - - - - - - - - - - - - - - - flatten — 704

MAP — 706

⋮

MAP — 706

Output — 708

# Fig. 7

Fig. 8

Fig. 9

EP 4 468 011 A1

Fig. 10

| | Europäisches Patentamt European Patent Office Office européen des brevets | **EUROPEAN SEARCH REPORT** | **Application Number** EP 23 17 5405 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MUNOZ CAMILA ET AL: "Self-supervised learning-based diffeomorphic non-rigid motion estimation for fast motion-compensated coronary MR angiography", MAGNETIC RESONANCE IMAGING, vol. 85, 13 October 2021 (2021-10-13), pages 10-18, XP093090441, TARRYTOWN, NY, US ISSN: 0730-725X, DOI: 10.1016/j.mri.2021.10.004 | 1-6, 8-12,14, 15 | INV. G01R33/565 G06N3/0464 G06N3/084 G06N3/02 |
| A | * sections 2.1, 2.2 and 2.3; first paragraph on p.17; figure 1 * | 7,13 | |
| X | HAIKUN QI ET AL: "End-to-end deep learning nonrigid motion-corrected reconstruction for highly accelerated free-breathing coronary MRA", MAGNETIC RESONANCE IN MEDICINE, WILEY-LISS, US, vol. 86, no. 4, 6 June 2021 (2021-06-06), pages 1983-1996, XP071675394, ISSN: 0740-3194, DOI: 10.1002/MRM.28851 | 1-6, 8-12,14, 15 | |
| A | * abstract, last paragraph of section 1, sections 2.1, 2.2, 2.3 and 2.4; figures 1,3 * | 7,13 | TECHNICAL FIELDS SEARCHED (IPC) G01R G06N |

The present search report has been drawn up for all claims

| Place of search | Date of completion of the search | Examiner |
|---|---|---|
| Munich | 12 October 2023 | Lebar, Andrija |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **HOSSBACK**. Deep learning-based motion quantification from k-space for fast model-based magnetic resonance imaging motion correction. *Medical Physics*, 2022, 1-14